# EUROPÄISCHE PATENTSCHRIFT

(11) **EP 1 608 870 B1**
(45) Veröffentlichungstag und Bekanntmachung des Hinweises auf die Patenterteilung: **29.09.2010**
(21) Anmeldenummer: 04720613.1
(22) Anmeldetag: 15.03.2004
(51) Int. Cl.: F02M 59/46, F02M 51/06, F02M 61/16, H01L 41/053, F16K 31/00

(54) **PIEZOELEKTRISCHER AKTOR MIT EINEM ZWEITEILIGEN HÜLSENFÖRMIGEN GEHÄUSE UND VERFAHREN ZUR HERSTELLUNG EINES GEHÄUSES FÜR EINEN PIEZOELEKTRISCHEN AKTOR**
PIEZOELECTRIC ACTUATOR COMPRISING A TWO-PART SLEEVE-TYPE HOUSING AND METHOD FOR PRODUCING A HOUSING FOR A PIEZOELECTRIC ACTUATOR
ACTIONNEUR PIEZO-ELECTRIQUE COMPRENANT UN LOGEMENT SOUS FORME DE GAINE EN DEUX PARTIES ET PROCEDE DE PRODUCTION D'UN LOGEMENT POUR UN ACTIONNEUR PIEZO-ELECTRIQUE

(30) Priorität: 02.04.2003 DE 10315067
(43) Veröffentlichungstag der Anmeldung: 28.12.2005
(73) Patentinhaber: Continental Automotive GmbH, 30165 Hannover (DE)
(72) Erfinder: KUSCHEL, Alexander, 09599 Freiberg (DE); LEWENTZ, Günter, 93093 Donaustauf (DE); UNRUH, Marcus, 93197 Zeitlarn (DE); VOIGT, Andreas, 09212 Limbach-Oberfrohna (DE)
(86) Internationale Anmeldenummer: PCT/EP2004/002674
(87) Internationale Veröffentlichungsnummer: WO 2004/088123

(56) Entgegenhaltungen:
- DE-A- 4 408 145
- DE-A- 19 538 791
- US-A- 5 775 600
- US-B1- 6 425 376
- PATENT ABSTRACTS OF JAPAN vol. 2000, no. 01, 31. Januar 2000 (2000-01-31) & JP 11 280932 A (TAIHEIYO CEMENT CORP), 15. Oktober 1999 (1999-10-15)
- RUMPHORST M: "EIN NEUES ELEKTRONISCHES HOCHDRUCK-EINSPRITZSYSTEM FUR DIESELMOTOREN A NEW ELECTRONIC HIGH PRESSURE INJECTION SYSTEM" , MTZ MOTORTECHNISCHE ZEITSCHRIFT, FRANCKH'SCHE VERLAGSHANDLUNG,ABTEILUNG TECHNIK. STUTTGART, DE, VOL. 56, NR. 3, PAGE(S) 142-148 XP000490673 ISSN: 0024-8525 Seite 145, Spalte 2

## Beschreibung

Piezoelektrischer Aktor mit einem zweiteiligen hülsenförmigen Gehäuse und Verfahren zur Herstellung eines Gehäuses für einen piezoelektrischen Aktor

Die Erfindung betrifft einen piezoelektrischen Aktor gemäß dem Oberbegriff des Anspruchs 1 und ein Verfahren zur Herstellung eines Gehäuses für einen piezoelektrischen Aktor gemäß Anspruch 8.

Piezoelektrische Aktoren werden in den verschiedensten technischen Bereichen, insbesondere in der Kraftfahrzeugtechnik eingesetzt. In der Kraftfahrzeugtechnik werden piezoelektrische Aktoren bei neuen Benzin- oder Dieseleinspritzsystemen in einem Einspritzventil eingesetzt, um eine präzise Steuerung der Einspritznadel zu ermöglichen. Die piezoelektrischen Aktoren steuern dabei die Einspritznadel entweder direkt oder indirekt über ein Ventil einer Druckkammer an, deren Druck die Position der Einspritznadel steuert. Piezoelektrische Aktoren sind im Ruhezustand auf Druck vorgespannt und weisen den Vorteil auf, dass eine Längung des piezoelektrischen Aktors mit hoher Dynamik erfolgt. Damit können sehr kurze Schaltzeiten erreicht werden.

Ein Nachteil der piezoelektrischen Aktoren besteht darin, dass die mit dem piezoelektrischen Aktor darstellbaren Hübe im Bereich von < 100 µm liegen. Der geringe Hub erfordert eine präzise Justierung des piezoelektrischen Aktors im Bezug auf das Stellglied, das vom piezoelektrischen Aktor betätigt werden soll. Ist der Abstand zu groß, so wird das Stellglied nicht mehr ausreichend betätigt und ist der Abstand zu klein, so kann es vorkommen, dass kein Leerhub mehr vorliegt. Der fehlende Leerhub führt beispielsweise bei der Betätigung eines Servoventils dazu, dass das Servoventil immer geöffnet ist und bewirkt eine Fehlfunktion des Einspritzventils. Der piezoelektrische Aktor ist in einem Gehäuse eingebracht, das zum Ausgleich von thermischen Längenänderungen vorzugsweise den gleichen thermischen Ausdehnungskoeffizienten wie der piezoelektrische Aktor aufweisen sollte. Materialien, die den gleichen thermischen Ausdehnungskoeffizienten wie der piezoelektrische Aktor aufweisen, sind jedoch relativ teuer und schwer zu bearbeiten. Deshalb werden im Stand der Technik Gehäuse verwendet, die aus zwei Hülsen aufgebaut sind. Die zwei Hülsen weisen unterschiedliche thermische Ausdehnungskoeffizienten auf, die in der Gesamtwirkung annähernd dem thermischen Ausdehnungskoeffizienten des piezoelektrischen Aktors entsprechen.

Aus DE 195 38 791 A1 ist ein piezoelektrischer Aktor für ein Kraftstoffeinspritzventil bekannt, der in einem Gehäuse eingebracht ist, das aus zwei Hülsen aufgebaut ist. Die zwei Hülsen sind übereinander angeordnet und liegen auf planen, ringförmigen Auflageflächen aufeinander auf.

Aus DE 44 08 145 A1 ist ein Flüssigkeitseinspritzventil bekannt, das eine erste Führungseinrichtung aufweist, die mit einem Endabschnitt eines stationären Innengehäuses verbunden ist. In der ersten Führungseinrichtung ist ein bewegliches Innengehäuse gleitend vorgesehen, um eine Bewegung des mit dem beweglichen Innengehäuse verbundenen beweglichen Ventils zu führen. Zudem ist eine zweite Führungseinrichtung vorgesehen, um das bewegliche Ventil in eine Position zwischen einem Endabschnitt mit großem Durchmesser und einem Sitzabschnitt des beweglichen Ventils gleitend zu führen. Gemäß dem Fluideinspritzventil wird, da das bewegliche Innengehäuse und das bewegliche Ventil durch eine erste Führungseinrichtung und eine zweite Führungseinrichtung in den jeweils vorstehenden Positionen axial geführt werden, die Abnutzung des Anschlagabschnitts des beweglichen Ventils, beruhend auf äußeren Kräften, gegenüber dem beweglichen Ventil verringert.

Aus der US 6,425,376 B1 ist ein Einspritzventil mit einem piezoelektrischen Aktor bekannt, der ein Gehäuse aufweist, das aus zwei Hülsen ausgebildet ist. Eine erste Hülse ist in eine zweite Hülse eingesteckt, wobei die zwei Hülsen über eine Schweißnaht miteinander verbunden sind.

Aus DE 195 38 791 A1 ist ein Piezosteuerventil für Kraftstoffeinspritzanlagen von Brennkraftmaschinen bekannt, das ein Gehäuse aufweist, das aus zwei Hülsenteilen ausgebildet ist. Die zwei Hülsenteile sind stirnseitig aufeinander gesetzt und miteinander verbunden. Die zwei Hülsenteile sind aus verschiedenen Werkstoffen mit unterschiedlichen Ausdehnungskoeffizienten hergestellt. Das oben liegende Hülsenteil ist aus Invar und das unten liegende Hülsenteil aus üblichem Stahl gefertigt. Im Gehäuse ist ein Piezoaktor vorgesehen, der ein Verschlussstück zur Steuerung der Einspritzung betätigt. Um zumindest annährend gleiche Längenausdehnungen des Piezoaktors einerseits und des zweiteiligen Ventilgehäuses andererseits zu erhalten, sind die Längen des aus Stahl bestehenden Hülsenteils und des aus Invar bestehenden Hülsenteils so gewählt, dass die Summe der Wärmedehnung dieser Hülsenteile der Wärmedehnung des Piezoaktors entspricht bzw., dass sich eine ausreichende Ausdehnungskompensation der Hülsenteile gegenüber dem Piezoaktor ergibt.

Aus DE 199 09 106 A1 ist eine temperaturkompensierte Aktoreinheit mit einem Piezoelement bekannt. Die Aktoreinheit weist ein Piezoelement auf, das in einem aus drei Hülsen bestehenden Gehäuse angeordnet ist. Die drei Hülsen sind form- und/oder kraftschlüssig ineinander gesteckt und zu einem einzigen Bauteil verbunden. Die Wirkstoffkombination der drei Hülsen ist so gewählt, dass deren thermische Ausdehnungen an die des Piezoelementes angepasst ist.

Die Aufgabe der Erfindung besteht darin, einen piezoelektrischen Aktor mit einem verbesserten Gehäuse bereit zu stellen.

Die Aufgabe der Erfindung wird durch den piezoelektrischen Aktor gemäß Anspruch 1 und durch das Verfahren gemäß Anspruch 8 gelöst. Ein Vorteil des piezoelektrischen Aktors nach Anspruch 1 besteht darin, dass die erste und zweite Hülse ineinander gesteckt sind. Dadurch wird verhindert, dass beim Verschweißen der zwei Hülsen Schmutz in den Innenraum des Gehäuses gelangt oder die Innenwände des Gehäuses beschädigt werden. Die ineinander gesteckten Randbereiche der Hülsen weisen seitliche Zentrierflächen auf, die einander zugeordnet sind. Dadurch wird eine präzise Justierung der ersten und der zweiten Hülse auf einer Achse erreicht.

Erfindungsgemäß sind die erste und die zweite Hülse über korrespondierende Zentrierausnehmungen präzise auf eine Achse zueinander justiert. Dadurch wird eine Fehljustierung der zwei Hülsen vermieden. Somit werden Beeinträchtigungen der Funktion des piezoelektrischen Aktors, die durch eine Fehlstellung der zwei Hülsen bewirkt werden, vermieden. Folglich ist die Langzeitstabilität für eine korrekte Funktionsweise des piezoelektrischen Aktors erhöht.

Das Verfahren nach Anspruch 8 berücksichtigt bei der Herstellung des Gehäuses, dass der Wärmeausdehnungskoeffizient des piezoelektrischen Aktors schwanken kann und deshalb die Längen der Hülsen angepasst werden.

Weitere vorteilhafte Ausführungsformen der Erfindung sind in den abhängigen Ansprüchen angegeben.

Da die Gesamtlänge des Gehäuses, die sich aus der effektiven Länge der ersten und der zweiten Hülse ergibt, ein wichtiges Maß für die präzise Justierung des piezoelektrischen Aktors darstellt, ist es wichtig, die Einschubtiefe der zweiten Hülse präzise festzulegen.

In einer weiteren bevorzugten Ausführungsform weist die erste Hülse eine Auflagefläche auf, die an einem nach innen abgestuften Randbereich ausgebildet ist. Damit steht ein Mittel zur Begrenzung der maximalen Einschubtiefe der zweiten Hülse zur Verfügung.

Vorzugsweise sind die Auflageflächen der ersten oder zweiten Hülse in Form von umlaufenden Ringflächen ausgebildet. Die Form der umlaufenden Ringfläche ist einfach herzustellen und bietet eine Auflage für den gesamten ringförmigen Rand der ersten bzw. der zweiten Hülse. Somit kann die erste Hülse mit einer Ringfläche auf der zweiten Hülse aufliegen. Somit wird eine präzise Ausrichtung der ersten oder zweiten Hülse zueinander ermöglicht.

In einer weiteren bevorzugten Ausführungsform sind die erste und die zweite Hülse über eine Schweißnaht miteinander verbunden. Die Schweißnaht ist an Außenflächen der ersten und der zweiten Hülse ausgebildet. Durch die abgestufte Form der Randbereiche der ersten oder der zweiten Hülse wird verhindert, dass beim Verschweißen der ersten und der zweiten Hülse die Innenwand des Gehäuses beschädigt wird, da ein abgestufter Randbereich zwischen dem Schweißbereich und der Innenwand des Gehäuses angeordnet ist.

Die Erfindung wird im folgenden anhand der Figuren näher erläutert. Es zeigen:
Figur 1 einen Querschnitt durch einen piezoelektrischen Aktor,
Figur 2 eine erste und eine zweite Hülse,
Figur 3 ein Gehäuse das nicht Teil der Erfindung ist, bestehend aus einer ersten und einer zweiten Hülse und
Figur 4 ein Gehäuse gemäß der vorhiegenden Erfindung mit nicht vollständig ineinander gesteckten ersten und zweiten Hülsen 8, 9.

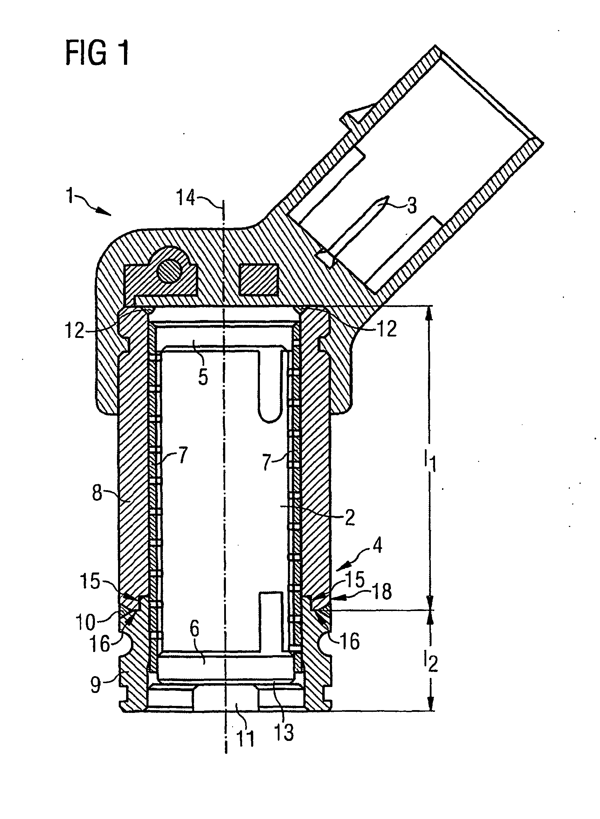

Figur 1 zeigt einen schematischen Querschnitt durch einen piezoelektrischen Aktor 1, der im Wesentlichen ein piezoelektrisches Element 2 mit elektrischen Anschlüssen 3 und ein Gehäuse 4 aufweist. Das piezoelektrische Element 2 weist eine Vielzahl von übereinander gestapelten piezoelektrischen Schichten auf, zwischen denen elektrisch leitenden Schichten angeordnet sind. Die elektrisch leitenden Schichten sind abwechselnd mit einem der zwei Anschlüsse 3 elektrisch leitend verbunden. Das piezoelektrische Element 2 ist zwischen einer Kopfplatte 5 und einer Bodenplatte 6 über eine Federhülse 7 eingespannt. Die Federhülse 7 ist mit der Kopfplatte 5 und der Bodenplatte 6 in ein hülsenförmiges Gehäuse 4 eingeschoben. Das Gehäuse 4 weist eine obere, erste Hülse 8 und eine untere, zweite Hülse 9 auf. Die erste und die zweite Hülse 8, 9 sind ineinander gesteckt und über eine Schweißnaht 10 miteinander verbunden. Die Schweißnaht 10 ist beispielsweise mit einem Laserschweißprozess oder einem elektromagnetischen Schweißprozess hergestellt worden. Die erste und die zweite Hülse 8, 9 sind aus unterschiedlichen Werkstoffen mit unterschiedlichen thermischen Ausdehnungskoeffizienten hergestellt. Die Werkstoffe mit den thermischen Ausdehnungskoeffizienten sind in der Weise ausgewählt, dass der thermische Ausdehnungskoeffizient des Gehäuses 4 annähernd dem thermischen Ausdehnungskoeffizienten des piezoelektrischen Elementes 2 mit Kopfplatte 5, Bodenplatte 6 und einer Steuerplatte 11 entspricht, die auf der Unterseite der Bodenplatte 6 ausgebildet ist. Auf diese Weise wird erreicht, dass keine Unterschiede in den Längen des Gehäuses 2 und des piezoelektrischen Elementes 2, mit Kopfplatte 5, Bodenplatte 6 und Steuerplatte 11 durch Temperaturschwankungen entstehen. Für die erste und die zweite Hülse 8, 9 werden als Materialien beispielsweise Stahl und Invar verwendet.

Die Kopfplatte 5 ist im oberen Randbereich über eine zweite Schweißnaht 12 mit dem oberen Randbereich der ersten Hülse 8 verschweißt. Die Steuerplatte 11 ist mit der Bodenplatte 6 und dem unteren Ende des piezoelektrischen Elementes 2 axial beweglich im Gehäuse 2 angeordnet. Soll nun ein Stellglied über den Aktor 1 betätigt werden, so werden die elektrischen Anschlüsse 3 bestromt. Folglich dehnt sich das piezoelektrische Element 2 gegen die Vorspannkraft der Federhülse 7 aus. Dabei wird die Steuerplatte 11 nach unten gegenüber dem Gehäuse 4 verschoben. Üblicherweise weisen piezoelektrische Elemente eine maximale Auslenkung von 100 µm bei der Bestromung auf. An der unteren Öffnung der zweiten Hülse 9 ist eine Membran 13 eingespannt, die umlaufend dicht mit dem inneren Randbereich der zweiten Hülse 9 verbunden ist. Damit wird das piezoelektrische Element gegenüber Umwelteinflüssen abgedichtet. Die Membran 13 ist beispielsweise in Form einer metallischen Membran ausgebildet. Die Membran 13 kann jedoch auch in jeder beliebigen anderen Ausführungsform ausgebildet sein.

Die Anordnung des piezoelektrischen Elementes 2 in der ersten und in der zweiten Hülse 8, 9 erfordert eine präzise Ausrichtung der ersten oder zweiten Hülse 8, 9 parallel zu einer Mittensymmetrieachse 14. Die präzise Ausrichtung der ersten und zweiten Hülse 8, 9 wird durch seitliche Zentrierflächen 21, 22 erreicht, die auf der Innenwandseite der ersten Hülse 8 und auf der Außenwandseite der zweiten Hülse 9 ausgebildet sind und einander zugeordnet sind.

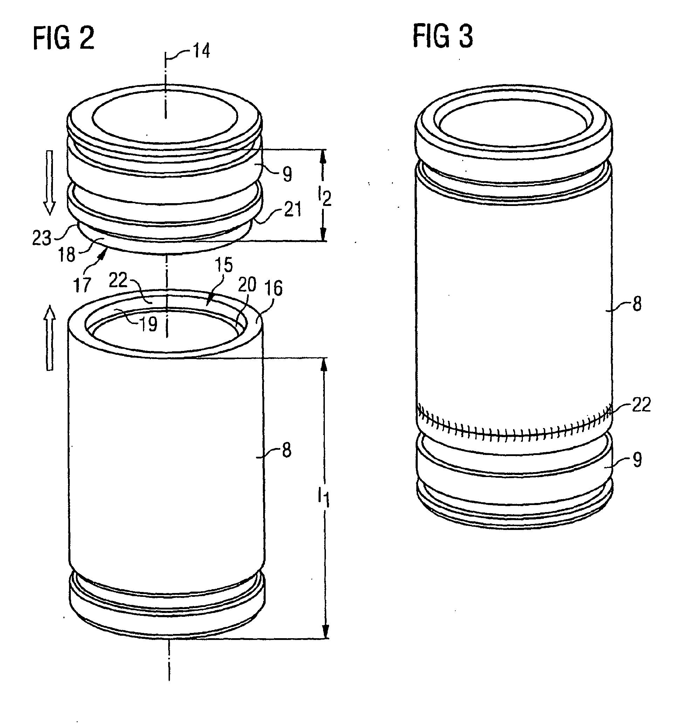

Figur 2 zeigt die erste und zweite Hülse vor der Montage zum Aktorgehäuse. Die erste Hülse 8 weist eine Zentrierausnehmung 19 auf der Innenseite eines Randbereiches 16 auf, die einem zweiten Randbereich 17 der zweiten Hülse 9 zugeordnet ist. Die Zentrierausnehmung 19 ist in dem gewählten Ausführungsbeispiel in Form einer ersten ringförmigen Nut ausgebildet, die in den Randbereich 16 auf der Innenseite der ersten Hülse 8 eingebracht ist. Durch die Zentrierausnehmung 19 wird eine erste Zentrierfläche 22 gebildet, die die Form einer Zylinderfläche aufweist. Im Querschnitt weist der Randbereich 16 der ersten Hülse 8 einen nach oben abgestuften Randbereich auf. Die erste und die zweite Hülse sind rotationssymmetrisch zur Mittensymmetrieachse 14 ausgebildet.

Der zweite Randbereich 17 der zweiten Hülse 9, der dem Randbereich 16 der ersten Hülse 8 zugeordnet ist, ist passend zur Form des Randbereiches 16 abgestuft ausgebildet. Der zweite Randbereich 17 weist eine zweite Zentrierausnehmung 18 auf, die auf der Außenseite in Form eine ringförmig umlaufende zweiten Nut ausgebildet ist. Durch die zweite Zentrierausnehmung 18 wird eine zweite zylinderförmige seitliche Zentrierfläche 23 gebildet. Im montierten Zustand der ersten und zweiten Hülse 8, 9 liegen die erste und zweite Zentrierfläche 22, 23 aneinander an, wie in Figur 1 dargestellt ist. Die

Länge des Gehäuses ergibt sich aus der Summe der Längen 11, 12 der ersten und der zweiten Hülse 8, 9. Die Längen 11 und 12 der ersten und der zweiten Hülse werden abhängig von dem Wärmeausdehnungskoeffizienten und der Länge des piezoelektrischen Aktors festgelegt. Die Wärmeausdehnungskoeffizienten der Aktoren können von Charge zu Charge variieren. Entsprechend sind die Längen 11, 12 der Hülsen unterschiedlich zu wählen. Durch die erfindungsgemäße Form des Gehäuses ist eine einfache Anpassung der Längen 11, 12 möglich, indem die Höhen der Abstufungen der Zentrierausnehmungen 18, 19 der Hülsen 8, 9 unterschiedlich gewählt werden. Somit können bei gleichbleibenden Längen der ersten und zweiten Hülse 8, 9 unterschiedlich lange Gehäuse 4 hergestellt werden.

Die erste Hülse 8 weist einen von der Außenseite her nach innen abgestuften ersten Randbereich 16 auf. Die zweite Hülse 9 weist einen Randbereich 17 auf, der von innen nach außen abgestuft ausgebildet ist. Die erste Zentrierausnehmung 19 bildet eine erste, ringförmig umlaufende Auflagefläche 20 aus. Die erste Auflagefläche 20 ist parallel zum Randbereich 16 ausgebildet, aber um die Tiefe der ersten Zentrierausnehmung 19 versetzt angeordnet.

Der zweite Randbereich 17 der zweiten Hülse 9 weist eine zweite Auflagefläche 21 auf, die durch die zweite Zentrierausnehmung 18 ausgebildet ist. Die zweite Auflagefläche 21 ist ebenfalls als ringförmig umlaufende Ringfläche ausgebildet, die parallel zum zweiten Randbereich 17 angeordnet ist, jedoch um die Tiefe der zweiten Zentrierausnehmung 18 zurückversetzt angeordnet ist.

Zur Herstellung des Gehäuses 4 wird die zweite Hülse 9 mit dem zweiten Randbereich 17 in die erste Hülse 8 eingeschoben. Die zweite Hülse 9 wird so tief in die erste Hülse 8 eingeschoben, daß die zweite Auflagefläche 21 der zweiten Hülse 9 von dem Randbereich 16 der ersten Hülse 8 noch beabstandet ist. Die zweite Zentrierfläche 23 des inneren Randbereiches 17 der zweiten Hülse 9 und die erste Zentrierfläche 22 des Randbereiches 16 der ersten Hülse 8 sind in der Weise aufeinander abgestimmt, dass eine Zentrierung der ersten und der zweiten Hülse 8, 9 im Bezug auf eine parallele Ausrichtung zur Mittensymmetrieachse 14 gegeben ist. Im einfachsten Fall sind die erste und zweite Zentrierfläche 22, 23 als Zylindermantelflächen ausgebildet. Es können jedoch auch andere Formen verwendet werden, die eine parallele Ausrichtung der ersten und der zweiten Hülse 8, 9 im Bezug auf die Mittensymmetrieachse 14 ermöglichen.

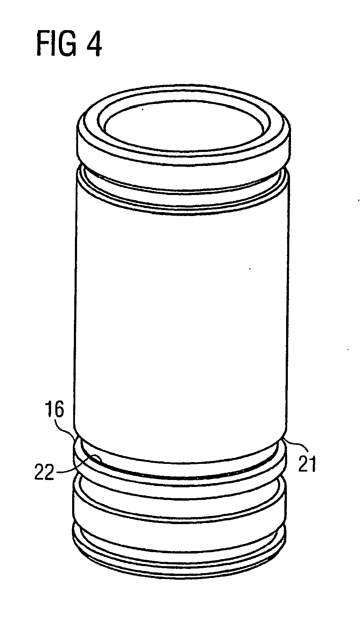

Figur 3 zeigt ein Gehäuse 4 welches nicht Teil der Erfindung ist, mit ineinander gesteckten ersten und zweiten Hülsen, wobei die erste und die zweite Hülse über die Schweißnaht 10 auf der Außenseite miteinander umlaufend verschweißt sind. In der Ausführungsform der Figur 3 liegt die erste Auflagefläche 21 auf dem Randbereich 16 auf. Je nach Ausführungsform kann auch ein Abstand zwischen dem Randbereich 16 und der ersten Auflagefläche 21 ausgebildet sein. Auf diese Weise können Längenänderungen des Gehäuses 4 erreicht werden, ohne dass erste und zweite Hülsen 8, 9 mit neuen Längen hergestellt werden müssen. Zur Kürzung der Länge 11 der zweiten Hülse 9 wird die zweite Nut 18 entsprechend hoch ausgebildet. Damit die zweite Hülse 9 mit der zweiten Auflagefläche 21 auf dem Randbereich 16 aufliegen kann, ist die erste Nut 19 entsprechend hoch auszubilden. Zur Kürzung der Länge 12 der ersten Hülse 8 ist es erforderlich, die erste Hülse 8 plan abzuschleifen. Zur Verlängerung der ersten und zweiten Hülse 8, 9 für die Erstellung des Gehäuses 4 werden die ersten und die zweiten Hülsen 8, 9 weniger tief ineinander gesteckt und miteinander verbunden. In dieser erfindungsgemäßen Ausführung ist der Randbereich 16 von der zweiten Auflagefläche 21 beabstandet, wie in Figur 4 dargestellt.

In das Gehäuse 4 der Figur 3 wird anschließend der piezoelektrische Aktor 1 gemäß Figur 1 eingebracht und ein Anschlussstecker mit Anschlüssen 3 angegossen.

Wie aus Figur 1 ersichtlich, bildet die abgestufte Form des Randbereiches 17 der zweiten Hülse 9 den Vorteil, dass beim Verschweißen der ersten mit der zweiten Hülse 8, 9 die Schweißstrahlung, beispielsweise Laserstrahlung oder elektromagnetische Strahlung, nicht in den Innenbereich des Gehäuses 4 gelangt, sondern immer von einer Wand des zweiten Randbereichs 17 abgefangen wird. Auf diese Weise wird eine Beschädigung der Innenwand des Gehäuses 4 durch den Schweißvorgang vermieden.

Vor der Herstellung des Gehäuses 4 wird die Länge und der thermische Ausdehnungskoeffizient einer Charge von piezoelektrischen Aktoren gemessen. Anschließend werden die erste bzw. die zweite Zentrierausnehmung 19, 18 in die erste bzw. zweite Hülse 8, 9 mit entsprechenden Höhen eingebracht, so dass die abgestuften Randbereiche 16, 17 der ersten und zweiten Hülse 8, 9 entsprechende Stufenhöhen aufweisen, damit die erste und zweite Hülse mit der gewünschten Überlappung ineinander geschoben werden können. Dadurch können gewünschte Längen 11, 12 für die erste und zweite Hülse 8, 9 eingestellt werden.

## Patentansprüche

1. Piezoelektrischer Aktor (1) mit einem zweiteiligen hülsenförmigen Gehäuse (4), in dem ein piezoelektrisches Element (2) mit einem Ende befestigt ist und dessen zweites Ende beweglich gegenüber dem Gehäuse (4) angeordnet ist, wobei das Gehäuse (4) eine erste und eine zweite Hülse (8, 9) aufweist, die in einer Achse angeordnet und miteinander verbunden sind, wobei die erste und zweite Hülse (8, 9) unterschiedliche thermische Ausdehnungskoeffizienten aufweisen, wobei
die zweite Hülse (9) mit einem Randbereich (17) in die erste Hülse (8) eingesteckt ist, wobei
die erste Hülse (8) auf einer Innenseite eines Randbereichs (16), in den die zweite Hülse (9) eingesteckt ist, eine erste Zentrierfläche (22) aufweist, wobei die zweite Hülse (9) auf der Außenseite des Randbereichs (17) eine zweite Zentrierfläche (23) aufweist, die der ersten Zentrierfläche (22) zugeordnet ist, **wobei eine zweite Auflagefläche (21) als ringförmig umlaufende Ringfläche ausgebildet ist, die parallel zum Randbereich** (17) der zweiten Hülse (9) **ausgebildet ist, dadurch gekennzeichnet, dass** die erste Zentrierfläche (22) durch eine erste Zentrierausnehmung (19) auf der Innenseite der ersten Hülse (8) ausgebildet ist, und dass die zweite Zentrierfläche (23) durch eine zweite Zentrierausnehmung (18) auf der Außenseite der zweiten Hülse (9) gebildet ist, und **dadurch**, dass der Randbereich (16) der ersten Hülse von der zweiten Auflagefläche (21) beabstandet ist.

2. Piezoelektrischer Aktor nach Anspruch 1, **dadurch gekennzeichnet, dass** der Randbereich (17) der zweiten Hülse (9) nach außen abgestuft ausgebildet ist und die zweite Auflagefläche (21) aufweist.

3. Piezoelektrischer Aktor nach Anspruch 1 oder 2, **dadurch gekennzeichnet, dass** der Randbereich (16) der ersten Hülse (8) nach innen abgestuft ist und eine erste Auflagefläche (20) aufweist.

4. Piezoelektrischer Aktor nach Anspruch 2 oder 3, **dadurch gekennzeichnet, dass** die erste und/oder zweite Auflagefläche (20, 21) als umlaufende Ringflächen ausgebildet sind.

5. Piezoelektrischer Aktor nach einem der Ansprüche 3 oder 4, **dadurch gekennzeichnet, dass** der zweite Randbereich (17) der zweiten Hülse (9) auf der ersten Auflagefläche (20) der ersten Hülse (8) aufliegt.

6. Piezoelektrischer Aktor nach einem der Ansprüche 1 bis 5, **dadurch gekennzeichnet, dass** die erste und die zweite Hülse (8, 9) über eine Schweißnaht (10) miteinander verbunden sind, und dass die Schweißnaht an Außenflächen der ersten und zweiten Hülse (8, 9) ausgebildet ist.

7. Piezoelektrischer Aktor nach Anspruch 6, **dadurch gekennzeichnet, dass** die Schweißnaht als Laserschweißnaht oder als Elektroschweißnaht ausgebildet ist.

8. Verfahren zum Herstellen eines Gehäuses (4) für einen piezoelektrischen Aktor (1), das aus zwei Hülsen (8, 9) aufgebaut ist, wobei
die zwei Hülsen (8, 9) aus Materialien mit unterschiedlichen thermischen Ausdehnungskoeffizienten bestehen,
**dadurch gekennzeichnet, dass** der thermische Ausdehnungskoeffizient des piezoelektrischen Aktors (1) gemessen wird, dass die zwei Hülsen (8,9) so tief ineinander gesteckt werden und miteinander verbunden werden, dass ein Gehäuse (4) erhalten wird, dessen thermischer Ausdehnungskoeffizient im wesentlichen dem thermischen Ausdehnungskoeffizienten des piezoelektrischen Aktors (1) entspricht.

9. Verfahren nach Anspruch 8, **dadurch gekennzeichnet, dass** die erste Hülse (8) eine innere Zentrierfläche (22) und die zweite Hülse (9) eine äußere Zentrierfläche (23) aufweisen, dass die Zentrierflächen (22, 23) in Form von Nuten ausgebildet sind, und dass die Tiefe der Nuten abhängig vom Ausdehnungskoeffizienten des piezoelektrischen Aktors (1) unterschiedlich tief ausgebildet werden, so dass Randbereiche (16, 17) der ersten und zweiten Hülse (8,9) aufeinander aufliegen und das Gehäuse (4) eine Länge aufweist, so dass der thermische Ausdehnungskoeffizient des Gehäuses (4) im wesentlichen dem thermischen Ausdehnungskoeffizienten des Aktors (1) entspricht.

## Claims

1. Piezoelectric actuator (1) comprising a two-part sleeve-type housing (4), in which one end of a piezoelectric element (2) is attached and with the second end of the element being arranged movably in relation to the housing (4), with the housing (4) having a first and a second sleeve (8, 9) which are arranged in one axis and connected to one another, with the first and second sleeve (8, 9) having different coefficients of thermal expansion, with
the second sleeve (9) being inserted with an edge area (17) into the first sleeve (8), with
the first sleeve (8), on an inner side of an edge area (16) into which the second sleeve (9) is inserted, having a first centring surface (22), with the second sleeve (9) having a second centring surface (23) on the outer side of the edge area (17) which is assigned to the first centring surface (22), with a second support surface (21) being embodied as a circumferential annular surface which is embodied in parallel to the edge area (17) of the second sleeve (9), **characterised in that** the first centring surface (22) is embodied by a first centring recess (19) on the inner side of the first sleeve (8) and that the second centring surface (23) is formed by a second centring recess (18) on the outer side of the second sleeve (9) and that the edge area (16) of the first sleeve is spaced away from the second support surface (21).

2. Piezoelectric actuator according to claim 1, **characterised in that** the edge area (17) of the second sleeve (9) is embodied with an outwards step and features the second support surface (21).

3. Piezoelectric actuator according to claim 1 or 2, **characterised in that** the edge area (16) of the first sleeve (8) is embodied with an inwards step and features a first support surface (20).

4. Piezoelectric actuator according to claim 2 or 3, **characterised in that** the first and/or second support surface (20, 21) are embodied as circumferential annular surfaces.

5. Piezoelectric actuator according to one of claims 3 or 4, **characterised in that** the second edge area (17) of the second sleeve (9) rests on the first support surface (20) of the first sleeve (8).

6. Piezoelectric actuator according to one of claims 1 to 5, **characterised in that** the first and the second sleeve (8, 9) are connected to each other by a weld seam (10) and that the weld seam is embodied on outer surfaces of the first and second sleeve (8, 9).

7. Piezoelectric actuator according to claim 6, **characterised in that** the weld seam is embodied as a laser weld seam or as an electric weld seam.

8. Method for producing a housing (4) for a piezoelectric actuator (1), constructed from two sleeves (8, 9), with the two sleeves (8, 9) consisting of materials with different coefficients of thermal expansion, **characterised in that** the coefficient of thermal expansion of the piezoelectric actuator (1) is measured, the two sleeves (8, 9) are pushed so deeply into one another and connected to each other that a housing (4) is obtained of which the coefficient of thermal expansion substantially corresponds to the coefficient of thermal expansion of the piezoelectric actuator (1).

9. The method according to claim 8, **characterised in that** the first sleeve (8) has an inner centring surface (22) and the second sleeve (9) has an outer centring surface (23), that the centring surfaces (22, 23) are embodied in the form of grooves and that the depth of the grooves are embodied differently depending on the coefficient of thermal expansion of the piezoelectric actuator (1), so that edge areas (16, 17) of the first and second sleeve (8, 9) rest on each other and the housing (4) has a length so that the coefficient of thermal expansion of the housing (4) substantially corresponds to the coefficient of thermal expansion of the actuator (1).

## Revendications

1. Actionneur piézoélectrique (1) comportant un boîtier en forme de gaine et composé de deux parties (4), boîtier dans lequel un élément piézoélectrique (2) est fixé par une extrémité et dont la seconde extrémité est agencée de manière mobile par rapport au boîtier (4), le boîtier (4) présentant une première et une seconde gaine (8, 9) qui sont disposées dans un axe et rattachées l'une à l'autre, la première et la seconde gaine (8, 9) présentant des coefficients de dilatation thermique différents, la seconde gaine (9) étant enfichée dans la première gaine (8) par une zone de bordure (17), la première gaine (8) présentant une première surface de centrage (22) sur une face interne d'une zone de bordure (16) dans laquelle la seconde gaine (9) est enfichée, la seconde gaine (9) présentant une seconde surface de centrage (23) sur la face externe de la zone de bordure (17), laquelle surface est placée en regard de la première surface de centrage (22), une seconde surface d'appui (21) étant réalisée sous la forme d'une surface annulaire circonférentielle qui est parallèle à la zone de bordure (17) de la seconde gaine (9), **caractérisé en ce que** la première surface de centrage (22) est formée d'un premier évidement de centrage (19) sur la face interne de la première gaine (8) et **en ce que** la seconde surface de centrage (23) est formée d'un second évidement de centrage (18) sur la face externe de la seconde gaine (9) et **en ce que** la zone de bordure (16) de la première gaine est placée à distance de la seconde surface d'appui (21).

2. Actionneur piézoélectrique selon la revendication 1, **caractérisé en ce que** la zone de bordure (17) de la seconde gaine (9) est réalisée avec des paliers à l'extérieur et présente la seconde surface d'appui (21).

3. Actionneur piézoélectrique selon la revendication 1 ou 2, **caractérisé en ce que** la zone de bordure (16) de la première gaine (8) est réalisée avec des paliers à l'intérieur et présente une première surface d'appui (20).

4. Actionneur piézoélectrique selon la revendication 2 ou 3, **caractérisé en ce que** la première et/ou la seconde surface d'appui (20, 21) est /sont réalisée (s) sous forme de surface(s) annulaire(s) circonférentielle(s).

5. Actionneur piézoélectrique selon l'une quelconque des revendications 3 ou 4, **caractérisé en ce que** la seconde zone de bordure (17) de la seconde gaine (9) repose sur la première surface d'appui (20) de la première gaine (8).

6. Actionneur piézoélectrique selon l'une quelconque des revendications 1 à 5, **caractérisé en ce que** la première et la seconde gaine (8, 9) sont rattachées l'une à l'autre par une soudure (10) et **en ce que** la soudure est réalisée sur les surfaces externes de la première et de la seconde gaine (8, 9).

7. Actionneur piézoélectrique selon la revendication 6, **caractérisé en ce que** la soudure est une soudure au laser ou une soudure à l'arc électrique.

8. Procédé de fabrication d'un boîtier (4) pour un actionneur piézoélectrique (1) qui est composé de deux gaines (8, 9), les deux gaines (8, 9) étant constituées de matériaux présentant des coefficients de dilation thermique différents,
**caractérisé en ce que** le coefficient de dilation thermique de l'actionneur piézoélectrique (1) est mesuré et **en ce que** les deux gaines (8, 9) sont emboîtées profondément l'une dans l'autre et rattachées l'une à l'autre si bien que l'on obtient un boîtier (4) dont le coefficient de dilatation thermique correspond sensiblement au coefficient de dilatation thermique de l'actionneur piézoélectrique (1).

9. Procédé selon la revendication 8, **caractérisé en ce que** la première gaine (8) comporte une surface de centrage interne (22) et la seconde gaine (9) une surface de centrage externe (23), **en ce que** les surfaces de centrage (22, 23) sont réalisées sous la forme de rainures et **en ce que** la profondeur des rainures diffère en fonction du coefficient de dilatation de l'actionneur piézoélectrique (1) de telle sorte que les zones de bordure (16, 17) de la première et de la seconde gaine (8, 9) reposent l'une sur l'autre et que le boîtier (4) présente une longueur telle que le coefficient de dilatation thermique du boîtier (4) correspond sensiblement au coefficient de dilatation thermique de l'actionneur (1).
